**Europäisches Patentamt**

**European Patent Office**

**Office européen des brevets**

(11) Publication number : **0 466 101 B1**

## EUROPEAN PATENT SPECIFICATION

(45) Date of publication of patent specification :
**14.12.94 Bulletin 94/50**

(51) Int. Cl.⁵ : **H01L 29/10,** H01L 29/74,
H01L 29/72

(21) Application number : **91111412.2**

(22) Date of filing : **09.07.91**

(54) **Power semiconductor device.**

(30) Priority : **10.07.90 JP 181733/90**

(43) Date of publication of application :
**15.01.92 Bulletin 92/03**

(45) Publication of the grant of the patent :
**14.12.94 Bulletin 94/50**

(84) Designated Contracting States :
**CH DE FR GB LI SE**

(56) References cited :
**PESC '88 RECORD, PROCEEDINGS OF THE
19TH ANNUAL IEEE POWER ELECTRONI-
CSSPECIALISTS CONFERENCE, HELD IN
KYOTO, JP, 11-14 APRIL 1988. vol. 2, NEW
YORK,US pages 903 - 907; T. OGURA ET AL.:
'Low switching loss, high power Gate Turn-Off
thyristors (GTOs) with n-buffer and new anode
short structure'
IEEE TRANSACTIONS ON ELECTRON DE-
VICES. vol. ED-23, no. 8, August 1976, NEW
YORKUS pages 823 - 825; P. M. VAN
ISEGHEM: 'P-i-n epitaxial structures for high-
power devices'**

(73) Proprietor : **Kabushiki Kaisha Toshiba
72, Horikawa-cho
Saiwai-ku
Kawasaki-shi (JP)**

(72) Inventor : **Fujiwara, Takashi, c/o Intellectual
Property Div.
Kabushiki Kaisha Toshiba,
1-1 Shibaura 1-chome
Minato-ku, Tokyo 105 (JP)**
Inventor : **Matsuda, Hideo, c/o Intellectual
Property Div.
Kabushiki Kaisha Toshiba,
1-1 Shibaura 1-chome
Minato-ku, Tokyo 105 (JP)**
Inventor : **Hiyoshi, Michiaki, c/o Intellectual
Property Div.
Kabushiki Kaisha Toshiba,
1-1 Shibaura 1-chome
Minato-ku, Tokyo 105 (JP)**
Inventor : **Suzuki, Hisashi, c/o Intellectual
Property Div.
Kabushiki Kaisha Toshiba,
1-1 Shibaura 1-chome
Minato-ku, Tokyo 105 (JP)**

(74) Representative : **Lehn, Werner, Dipl.-Ing. et al
Hoffmann, Eitle & Partner,
Patentanwälte,
Postfach 81 04 20
D-81904 München (DE)**

## Description

This invention relates to a semiconductor device, and more particularly to a high-power bipolar composite element.

Bipolar composite elements, such as GTOs or IGBTs, are generally used for large current-carrying semiconductor devices.

Such large current-carrying semiconductor devices using bipolar composite elements are employed in inverters, converters, or the like, where those composite elements consume an extremely large amount of power. Therefore, to obtain a semiconductor device with higher efficiency and better performance, it is necessary to minimize the power consumption of elements used.

The amount of power consumed by elements is given by the following equation:

$$P = V_{TM} \cdot I_{TM} \cdot D + f(E_{on} + E_{off}) \quad (1)$$

where P is the amount of power consumed, $V_{TM}$ the forward voltage drop, $I_{TM}$ the on-current, D the duty, f the frequency, $E_{on}$ the turn-on loss, and $E_{off}$ the turn-off loss.

In equation (1), the term $V_{TM} \cdot I_{TM} \cdot D$ is known as the steady state loss, and the term $f(E_{on} + E_{off})$ the switching loss.

High withstand-voltage elements (e.g., GTOs), which are used in devices whose rated blocking voltage exceeds 4500V, are composed of four layers: the n-type cathode layer, p-base layer, n-type base layer, and p-type anode layer. With this arrangement, to reduce the steady state loss, it is desirable to make the n-type base layer thinner. Just thinning the layer, however, permits the depletion layer extending within the n-type base layer to reach the p-type emitter layer, causing punch-through.

To overcome this problem, devices that have an n+-type buffer layer of a relatively high concentration between the n-type base and p-type anode layers are widely used (see, for example, PESC '88 RECORD, Proceedings of the 19th Annual IEEE Power Electronics Specialists Conference, Kyoto, JP, vol. 2, pages 903-907). The formation of the n+-type layer buffer between the n-type base and p-type anode layers enables the n-type base layer to be thinned without creating a punch-through problem. For example, in the case of a GTO whose rated blocking voltage is 6000V, the presence and absence of the n+-type buffer layer makes the following difference:

[Absence of the n+-type buffer layer]

With the base-layer specific resistance ranging from 300 Ω·cm to 360 Ω·cm, the thickness of the n-type base layer must be approximately 970 μm.

[Presence of the n+-type buffer layer]

With the n-type base-layer specific resistance of 600 Ω·cm, the required thickness of the n-type base layer reduces to approximately 550 μm.

With the 550-μm-thick n-type base layer of a specific resistance of 600 Ω·cm, however, the depletion layer will reach the n+-type buffer layer at voltages on the order of 1200 to 1700 V. This causes a high electric field to be applied to the n+-type buffer layer in practical use (at voltages on the order of 3900 to 4800 V). When the GTO is turned off in this state, a large quantity of holes from the p-type anode layer are injected into the n-type base layer, slowing the decay of the tail current. With a high voltage during turning off, the large tail current creates a large amount of switching loss.

That is, as the n-type base layer becomes thinner, the steady state loss decreases, while the switching loss increases.

The object of the present invention is to provide a semiconductor device that overcomes the problem that the thinning of the n-type base layer by formation of the n+-type buffer layer increases the switching loss.

The foregoing object is accomplished by a semiconductor device, comprising: an emitter layer of a first conductivity type having a main surface and an opposite surface; a buffer layer of a second conductivity type formed on the main surface of the emitter layer of the first conductivity type; an anode electrode formed on the opposite surface of the emitter of the first conductivity type; a first base layer of the second conductivity type which is formed on the buffer layer of the second conductivity type with the impurity concentration of the first base layer being lower than that of the buffer layer, a second base layer of the first conductivity type formed on the first base layer; an emitter layer of the second conductivity type formed on the base layer of the first conductivity type; and a cathode electrode formed on the emitter layer of the second conductivity type, characterized in that and in which said first base layer has thickness and impurity concentration chosen so that the tip of the depletion layer reaches the buffer layer at a reverse bias voltage across the junction between said first and second base layers having a value in the vicinity of the maximum value of the rated voltage;

This invention can be more fully understood from the following detailed description when taken in conjunction with the accompanying drawings, in which:

Fig. 1 is a sectional view for a semiconductor device according to an embodiment of the present invention;

Fig. 2 shows an impurity concentration profile for a cross section taken along line 2-2 of Fig. 1;

Figs. 3 and 4 each show impurity concentration profiles for conventional semiconductor devices;

Fig. 5 illustrates the relationship between the steady state loss and switching loss of a GTO with a rated blocking voltage of 6000 V;

Fig. 6 is a sectional view for a shorted-anode GTO according to a second embodiment of the present invention; and

Fig. 7 illustrates the relationship between the specific resistance and thickness of the n-type base layer for achieving the present invention.

Referring to the accompanying drawings, embodiments of the present invention will be explained.

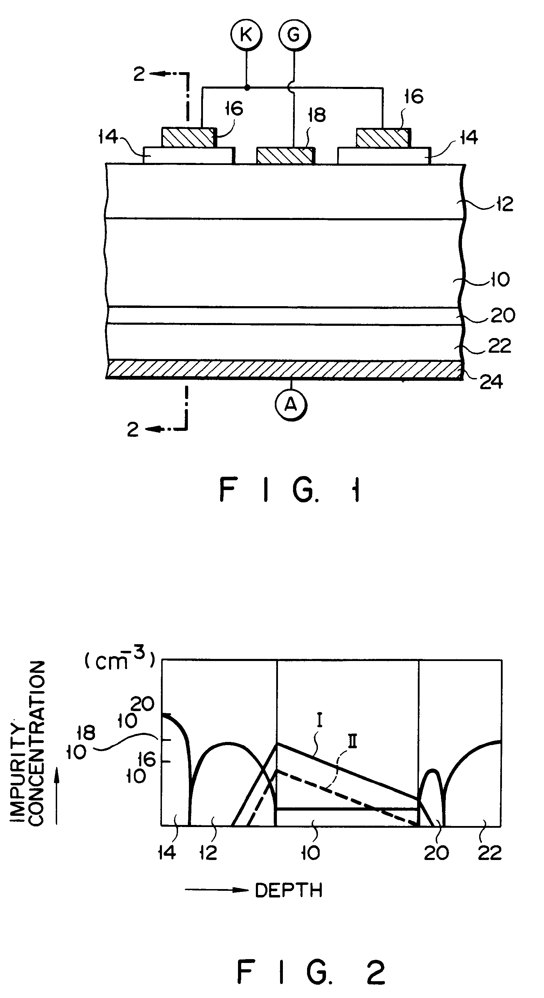

Fig. 1 is a sectional view for a GTO according to a first embodiment of the present invention.

As illustrated, on one surface of an n-type base layer 10 whose specific resistance is on the order of 300 to 360 $\Omega \cdot$cm, a p-type base layer 12 is formed. Formed on the p-type base layer 12 are n-type cathode layers 14, on which cathode electrodes 16 are formed. Each of the cathode electrodes 16 is connected to a cathode terminal K. Also formed on the p-type base layer 12 is a gate electrode 18, which is connected to a gate terminal G. On the other surface of the n-type base layer 10, an $n^+$-type buffer layer 20 of a high impurity concentration is formed. Formed on the $n^+$-type buffer layer 20 is a p-type anode layer 22, on which an anode electrode 24 is formed. The anode electrode 24 is connected to an anode terminal A.

With such an arrangement, to obtain, for example, a rated blocking voltage of 6000 V, the n-type base layer 10 in this invention has a specific resistance of on the order of 300 to 360 $\Omega \cdot$cm and a thickness of approximately 650 $\mu$m.

With the n-type base layer 10, when the voltage applied across the anode and cathode is raised to the range from 3900 to 4800 V, 65 to 80% of the rated blocking voltage, the tip of the depletion layer extending within the n-type base layer 10 is beginning to reach the $n^+$-type buffer layer 20.

Fig. 2, illustrating this situation, shows an impurity concentration profile for a cross section taken along line 2-2 of Fig. 1, in which the growth of the depletion layer is depicted.

Line I in Fig. 2 indicates the growth of the depletion layer at the rated voltage or at 6000 V, whereas line II shows the depletion layer growth at the turn-off voltage in practical use or in the voltage range of 3900 to 4800 V.

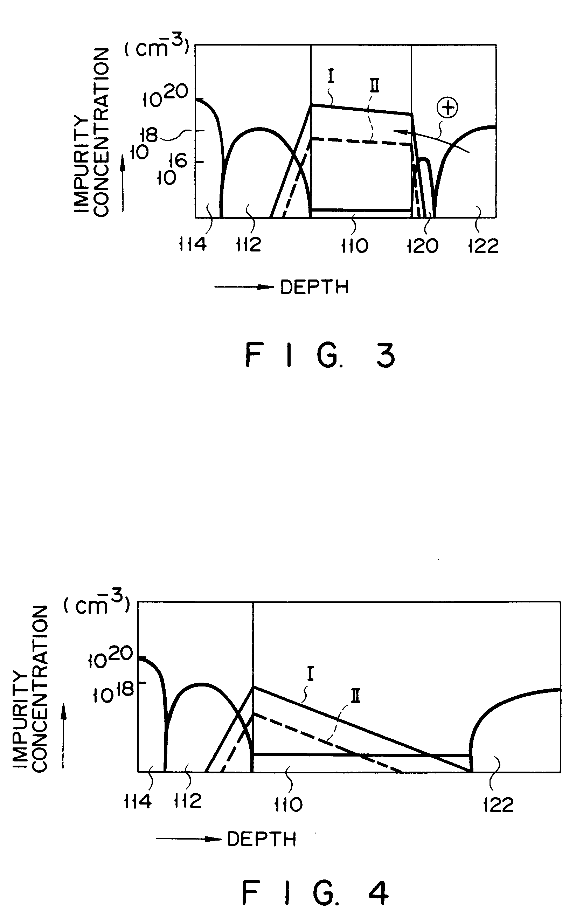

Fig. 3 shows an impurity concentration profile for a conventional GTO with an $n^+$-type buffer layer.

In Fig. 3, numeral 110 indicates the n-type base layer, 112 the p-type base layer, 114 the n-type cathode layer, 120 the $n^+$-type buffer layer, and 122 the p-type anode layer.

As with Fig. 2, line I in Fig. 3 indicates the growth of the depletion layer at the rated voltage or at 6000 V, whereas line II shows the depletion layer growth at the turn-off voltage in practical use or in the voltage range of 3900 to 4800 V.

As illustrated, in the conventional GTO with the $n^+$-typebuffer layer, the depletion layer shown by line II is controlled by the $n^+$-type buffer layer 114 so as not to come into contact with the p-type anode layer. During turning off, an extremely high electric field is applied to the $n^+$-buffer 114, which permits a large quantity of holes from the p-type anode layer 112 to be injected into the n-base layer 110, thereby increasing the switching loss.

Fig. 4 shows an impurity profile for a conventional GTO without an $n^+$-type buffer layer. The same parts in Fig. 4 and Fig. 3 are indicated by the same reference characters.

As illustrated, a conventional GTO without an $n^+$-type buffer layer has the very thick n-type base layer 110, so that the depletion layer distribution shown by line II prevents a high electric field from being applied to and around the interface between the n-type base layer and p-type anode layer. The thick n-type base layer 110, however, increases the steady state loss.

With a GTO according to this invention, as shown by line II in Fig. 2, the depletion layer is beginning to reach the $n^+$-type buffer layer 20 at the turn-off voltage in practical use, or in the range of 65 to 80% of the rated blocking voltage. This prevents the injection of holes from the p-type anode layer into the n-type base layer, which raised a problem in conventional devices as explained in Fig. 3. Accordingly, the switching loss can be reduced.

In the range larger than approximately 80% of the rated blocking voltage, as shown by line I in Fig. 2, the growth of the depletion layer is suppressed by the $n^+$-type buffer layer 20, which causes no punch-through. Therefore, it is unnecessary to form a thick n-type base layer unlike the conventional device as described in Fig. 4, which reduces the steady state loss.

As described above, by causing the tip of the depletion layer to reach the n-type base layer 10 in the voltage range of 65 to 80% of the rated blocking voltage or near the maximum voltage during turn-off, both the steady state loss and switching loss can be reduced sufficiently, which decreases the power consumption, the sum of both losses.

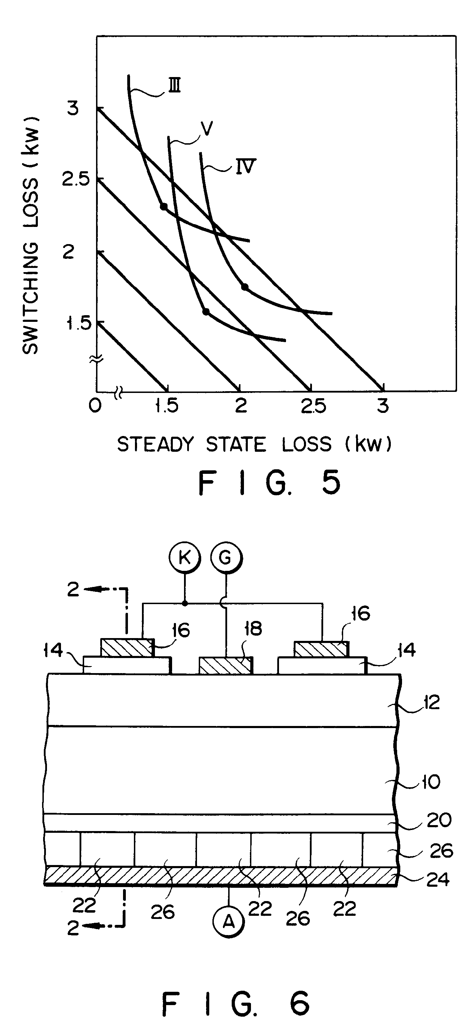

Fig. 5 shows the relationship between the steady state loss and switching loss of a GTO with a rated blocking voltage of 6000 V.

In Fig. 5, line III indicates the results of a conventional GTO with a buffer layer, whereas line IV represents the results of a conventional GTO without a buffer layer. Line V shows the results of a GTO according to this invention.

As seen from Fig. 5, with the GTO according to this invention, the sum of the switching loss and the steady state loss can be minimized, which reduces the power consumption.

Fig. 6 is a sectional view for a shorted-anode GTO according to a second embodiment of this invention. The same parts in Fig. 6 and Fig. 1 are indicated by the same reference characters and the explanation will be only focused on the different parts.

The GTO shown in Fig. 6 is obtained by forming an additional n-type shorted-anode layer 26 between the $n^+$-type buffer layer 20 and anode electrode 24 in the GTO of Fig. 1.

With the shorted-anode GTO, the tip of the depletion layer extending within the n-type base layer 10 is also caused to reach the $n^+$-type buffer layer 20 in the range of 65 to 80% of the rated blocking voltage. For example, to obtain a rated blocking voltage of 6000 V, the thickness of the n-type base layer 10 is set for approximately 650 μm and its specific resistance for on the order of 300 to 360 Ω·cm.

The impurity profile for the cross section taken along line 2-2 of Fig. 6 is the same as the first embodiment or the profile as shown in Fig. 2.

As described, this invention is also applicable to shorted-anode GTOs.

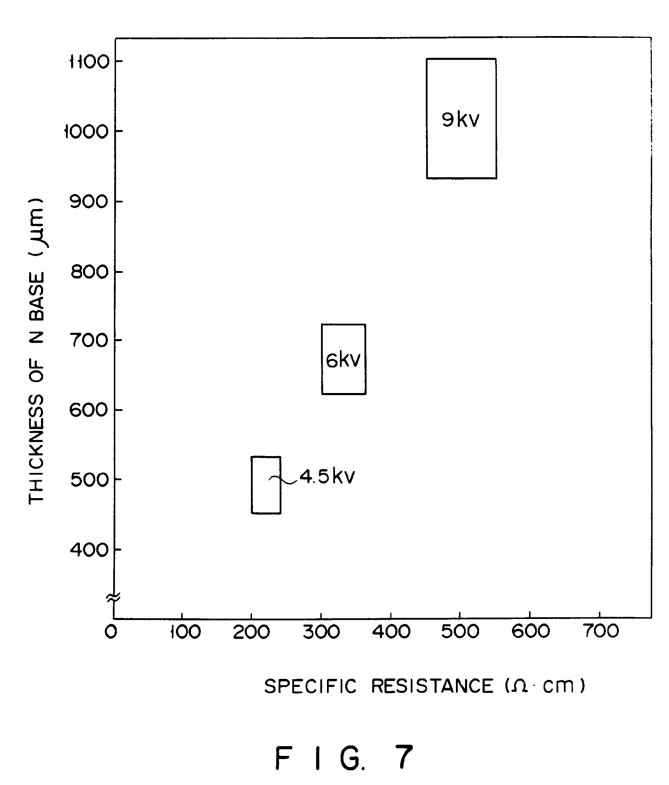

Fig. 7 illustrates the relationship between the specific resistance and thickness of the n-type base layer which enables the tip of the depletion layer to reach the $n^+$-type buffer layer in the range of 65 to 80% of the rated blocking voltage in a GTO according to the present invention.

As shown in Fig. 7, for a rated blocking voltage of 4500 V, it is desirable to set the specific resistance for on the order of 200 to 250 Ω·cm and the thickness for on the order of 450 to 550 μm. Similarly, for a rated blocking voltage of 6000 V, it is desirable to set the specific resistance for on the order of 300 to 380 Ω·cm and the thickness for on the order of 620 to 750 μm; and for a rated blocking voltage of 9000 V, it is favorable to set the specific resistance for on the order of 450 to 550 Ω·cm and the thickness for on the order of 940 to 1100 μm. Although not shown in Fig. 7, for a rated blocking voltage of 5000 V, it is preferable to set the thickness of the n-type base layer for approximately 520 μm and its specific resistance for on the order of 220 to 260 Ω·cm; for a rated blocking voltage of 7000 V, it is preferred to set the thickness for approximately 700 μm and the specific resistance for on the order of 340 to 400 Ω·cm.

While in the above embodiments, this invention is applied to a GTO with a rated blocking voltage of 6000 V, it is not restricted to this and may be applied to other bipolar composite elements including IGBTs.

## Claims

1. A semiconductor device comprising an emitter layer (22) of a first conductivity type having a main surface and an opposite surface, a buffer layer (20) of a second conductivity type formed on the main surface of said emitter layer (22) of the first conductivity type, an anode electrode (24) formed on the opposite surface of said emitter (22) of the first conductivity type, a first base layer (10) of the second conductivity type formed on said buffer layer (20) of the second conductivity type, said base layer (10) of the second conductivity type having an impurity concentration lower than that of said buffer layer (20), a second base layer (12) of the first conductivity type formed on said first base layer (10), an emitter layer (14) of the second conductivity type formed on said second base layer (12), and a cathode electrode (16) formed on said emitter layer (14) of the second conductivity type, characterized in that:

said first base layer (10) has thickness and impurity concentration chosen so that the tip of the depletion layer reaches said buffer layer (20) at a reverse bias voltage across the junction between said first and second base layers having a value in the vicinity of the maximum value of the rated blocking voltage.

2. The semiconductor device according to claim 1, characterized in that said vicinity of the maximum value of the rated blocking voltage is in the range of 65% to 80% of the rated voltage.

3. The semiconductor device according to claim 1, characterized by further comprising a gate electrode (18) formed on said base second layer (12).

4. The semiconductor device according to claim 1, characterized by further comprising a shorted-anode region (24) of the second conductivity type formed in said emitter layer (22) of the first conductivity type between said buffer layer (20) and said anode electrode (24).

5. The semiconductor device according to claim 1, characterized in that said first base layer (10) of the second conductivity type has a resistivity ranging from 200 to 250 Ω·cm and a thickness ranging from 450 to 550 μm, when said rated blocking voltage is 4500 V.

6. The semiconductor device according to claim 1, characterized in that said first base layer (10) of the second conductivity type has a resistivity ranging from 300 to 380 Ω·cm and a thickness ranging from 620 to 750 μm, when said rated blocking voltage is 6000 V.

7. The semiconductor device according to claim 1, characterized in that said first base layer of the second conductivity has a resistivity ranging from 450 to 550 Ω·cm and a thickness ranging from 940 to 1100 μm, when said rated blocking voltage is 9000 V.

## Patentansprüche

1. Halbleitervorrichtung, die aufweist:
   - eine Emitterschicht (22) eines ersten Leitfähigkeitstyps, die eine Hauptoberfläche und eine gegenüberliegende Oberfläche aufweist;
   - eine Pufferschicht (20) des zweiten Leitfähigkeitstyps, die auf der Hauptoberfläche der Emitterschicht (22) des ersten Leitfähigkeitstyps gebildet ist;
   - eine Anodenelektrode (24), die auf der gegenüberliegenden Oberfläche des Emitters (22) des ersten Leitfähigkeitstyps gebildet ist;
   - eine erste Basisschicht (10) des zweiten Leitfähigkeitstyps, die auf der Pufferschicht (20) des zweiten Leitfähigkeitstyps gebildet ist, wobei die Basisschicht (10) des zweiten Leitfähigkeitstyps eine Fremdatomkonzentration aufweist, die niedriger als die der Pufferschicht (20) ist;
   - eine zweite Basisschicht (12) des ersten Leitfähigkeitstyps, die auf der ersten Basisschicht (10) gebildet ist;
   - eine Emitterschicht (14) des zweiten Leitfähigkeitstyps, die auf der zweiten Basisschicht (12) gebildet ist; und
   - eine Kathodenelektrode (16), die auf der Emitterschicht (14) des zweiten Leitfähigkeitstyps gebildet ist;
   dadurch **gekennzeichnet,**
   - daß die erste Basisschicht (10) eine Dicke und eine Fremdatomkonzentration aufweist, die so gewählt sind, daß die Spitze der Verarmungsschicht die Pufferschicht (20) bei einer am Übergang zwischen der ersten und der zweiten Basisschicht liegenden Sperrspannung erreicht, die einen Wert in der Nähe des Maximalwertes der sperrenden Nennspannung besitzt.

2. Halbleitervorrichtung nach Anspruch 1, dadurch **gekennzeichnet**, daß die Nähe des Maximalwertes der sperrenden Nennspannung im Bereich von 65% bis 80% der Nennspannung liegt.

3. Halbleitervorrichtung nach Anspruch 1, dadurch **gekennzeichnet**, daß die weiter eine Gatterelektrode (18) aufweist, die auf der zweiten Basisschicht (12) gebildet ist.

4. Halbleitervorrichtung nach Anspruch 1, dadurch **gekennzeichnet,** daß sie weiter einen kurzgeschlossenen Anodenbereich (24) des zweiten Leitfähigkeitstyps aufweist, der in der Emitterschicht (22) des ersten Leitfähigkeitstyps zwischen der Pufferschicht (20) und der Anodenelektrode (24) gebildet ist.

5. Halbleitervorrichtung nach Anspruch 1, dadurch **gekennzeichnet**, daß die erste Basisschicht (10) des zweiten Leitfähigkeitstyps einen spezifischen Widerstand im Bereich von 200 bis 250 Ω cm und eine Dicke im Bereich von 450 bis 550 µm besitzt, wenn die sperrende Nennspannung 4.500 V beträgt.

6. Halbleitervorrichtung nach Anspruch 1, dadurch **gekennzeichnet**, daß die erste Basisschicht (10) des zweiten Leitfähigkeitstyps einen spezifischen Widerstand im Bereich von 300 bis 380 Ω cm und eine Dicke im Bereich von 620 bis 750 µm besitzt, wenn die sperrende Nennspannung 6.000 V beträgt.

7. Halbleitervorrichtung nach Anspruch 1, dadurch **gekennzeichnet**, daß die erste Basisschicht des zweiten Leitfähigkeitstyps einen spezifischen Widerstand im Bereich von 450 bis 500 Ω cm und eine Dicke im Bereich von 940 bis 1.100 µm besitzt, wenn die sperrende Nennspannung 9.000 V beträgt.

## Revendications

1. Dispositif semi-conducteur comprenant une couche d'émetteur (22) d'un premier type de conductivité ayant une surface principale et une surface opposée, une couche tampon (20) d'un second type de conductivité formée sur la surface principale de ladite couche d'émetteur (22) du premier type de conductivité, une électrode d'anode (24) formée sur la surface opposée dudit émetteur (22) du premier type de conductivité, une première couche de base (10) du second type de conductivité formée sur ladite couche tampon (20) du second type de conductivité, ladite couche de base (10) du second type de conductivité ayant une concentration d'impureté inférieure à celle de ladite couche tampon (20), une seconde couche de base (12) du premier type de conductivité formée sur ladite première couche de base (10), une couche d'émetteur (14) du second type de conductivité formée sur ladite seconde couche de base (12), et une électrode de cathode (16) formée sur ladite couche d'émetteur (14) du second type de conductivité, caractérisé en ce que :

   ladite première couche de base (10) a une épaisseur et une concentration d'impureté choisies de sorte que l'extrémité de la couche d'appauvrissement atteint ladite couche tampon (20) à une tension de polarisation inverse à travers la jonction entre lesdites première et seconde couches de base ayant une valeur au voisinage de la valeur maximum de la tension de blocage nominale.

2. Dispositif semi-conducteur selon la revendication 1, caractérisé en ce que ledit voisinage de la valeur maximum de la tension de blocage nominale est dans l'intervalle de 65 % à 80 % de la tension de blocage nominale.

3. Dispositif semi-conducteur selon la revendication 1, caractérisé en ce qu'il comprend en outre une électrode de grille (18) formée sur ladite seconde couche de base (12).

4. Dispositif semi-conducteur selon la revendication 1, caractérisé en ce qu'il comprend en outre une zone d'anode raccourcie (24) du second type de conductivité formée dans ladite couche d'émetteur (22) du premier type de conductivité entre ladite couche tampon (20) et ladite électrode d'anode (24).

5. Dispositif semi-conducteur selon la revendication 1, caractérisé en ce que ladite première couche de base (10) du second type de conductivité a une résistivité comprise dans l'intervalle de 200 à 250 $\Omega\cdot$cm et une épaisseur comprise dans l'intervalle de 450 à 550 $\mu$m, lorsque ladite tension de blocage nominale est de 4500V.

6. Dispositif semi-conducteur selon la revendication 1, caractérisé en ce que ladite première couche de base (10) du second type de conductivité a une résistivité comprise dans l'intervalle de 300 à 380 $\Omega\cdot$cm et une épaisseur comprise dans l'intervalle de 620 à 750 $\mu$m, lorsque ladite tension de blocage nominale est de 6000V.

7. Dispositif semi-conducteur selon la revendication 1, caractérisé en ce que ladite première couche de base du second type de conductivité a une résistivité comprise dans l'intervalle de 450 à 550 $\Omega\cdot$cm et une épaisseur comprise dans l'intervalle de 940 à 1100 $\mu$m lorsque ladite tension de blocage nominale est de 9000V.

F I G. 1

F I G. 2

F I G. 3

F I G. 4

8

F I G. 5

F I G. 6

F I G. 7